# EUROPÄISCHE PATENTSCHRIFT

(11) **EP 2 097 979 B1**
(45) Veröffentlichungstag und Bekanntmachung des Hinweises auf die Patenterteilung: **05.09.2018**
(21) Anmeldenummer: 07856265.9
(22) Anmeldetag: 27.11.2007
(51) Int. Cl.: E05F 15/46

(54) **ANORDNUNG ZUR DETEKTION VON KÖRPERTEILEN MITTELS ABSORPTION EINES ELEKTRISCHEN NAHFELDES**
ARRANGEMENT FOR THE DETECTION OF BODY PARTS BY ABSORBING AN ELECTRIC NEAR FIELD
SYSTÈME DE DÉTECTION DE PARTIES D'UN CORPS PAR ABSORPTION D'UN CHAMP ÉLECTRIQUE PROCHE

(30) Priorität: 27.11.2006 DE 102006056240; 11.01.2007 DE 102007001688
(43) Veröffentlichungstag der Anmeldung: 09.09.2009
(73) Patentinhaber: Microchip Technology Germany GmbH, 82205 Gilching (DE)
(72) Erfinder: FASSHAUER, Peter, 85579 Neubiberg (DE)
(74) Vertreter: sgb europe
(86) Internationale Anmeldenummer: PCT/EP2007/010293
(87) Internationale Veröffentlichungsnummer: WO 2008/064864

(56) Entgegenhaltungen:
- WO-A-00/52657
- WO-A-89/08352
- DE-A1- 4 006 119
- DE-C1- 10 220 725

## Beschreibung

Für die Detektion einer Annäherung eines menschlichen Körpers an ein Objekt gibt es verschiedene, insbesondere kapazitive Verfahren, die meist nach dem Prinzip arbeiten, dass von einer Elektrode ein elektrisches Wechselfeld abgestrahlt wird, das sich bei Annäherung eines Körpers oder eines Körperteiles hinsichtlich der Feldverteilung gegenüber der Umgebung ändert und diese Änderung mit einer geeigneten Elektronik detektiert wird.

Eine formale Beschreibung dieses Effektes besteht darin, die Kapazität dieser Elektrode zu betrachten, die sich bei Annäherung infolge der geänderten Feldverteilung ebenfalls ändert. Beim Einsatz solcher Näherungssensoren besteht insbesondere im Freien ein großes Problem in der Empfindlichkeit gegenüber einwirkender Feuchtigkeit wie durch Regen oder Schnee auf die Elektrode, die zu einer Dielektrizitätsänderung und damit Kapazitätsänderung führt. Dies kann die Detektionssicherheit erheblich beeinträchtigen. Ferner sind derartige Sensoren sehr empfindlich gegen Einflüsse von Metallteilen in der Nähe der Sensorelektrode, da diese Metallteile die Kapazität der Sensorelektrode erheblich verändern, besonders wenn die Metallteile bewegt werden, wie z.B. bei Heckklappen, Schiebetüren und Schiebedächern von Automobilen. Dies muss dann durch häufig sehr aufwendige
Abschirmmaßnahmen verhindert werden.

Die internationale Patentanmeldung WO 00/52657 beschreibt einen Näherungssensor. Die deutsche Patentschrift DE 102 20 725 beschreibt eine Vorrichtung zum Erkennen eines Hindernisses in dem Öffnungsbereich eines bewegbaren Schließelements. Die deutsche Offenlegungsschrift DE 4006119 beschreibt ein kapazitives Wegaufnehmersystem.

Aufgabe der vorliegenden Erfindung ist es, eine Sensoranordnung zu entwickeln, die die aufgezeigten Nachteile vermeidet und ohne größeren Aufwand an beliebigen Objekten, vorzugsweise zur Absicherung gegen Gefährdungen durch Einklemmen im Automobilbereich eingesetzt werden kann.

Diese Aufgabe wird durch die Merkmale des unabhängigen Anspruchs 1 gelöst. Vorteilhafte Ausgestaltungen der Detektionsanordnung sind Gegenstand der Unteransprüche.

Die Erfindung richtet sich weiterhin auf eine Detektionsanordnung zur Erfassung der Präsenz eines Objektes, insbesondere eines Lebewesens in einem Bahnraum der als solcher von einer bewegbaren Struktur durchsetzt wird. Insbesondere richtet sich die Erfindung hierbei auf eine Detektionsanordnung durch welche die Präsenz eines Menschen im Bewegungsbereich der Heckklappe eines Kraftfahrzeuges erfasst werden kann. Erfindungsgemäss umfasst die Detektionsanordnung eine Transmitterelektrodeneinrichtung zur Einkoppelung eines elektrischen Wechselfeldes in die Observationszone sowie deren Umgebungsbereich, und eine Receiverelektrodeneinrichtung zur Erfassung eines elektrischen Feldes in der Observationszone sowie des genannten Umgebungsbereiches, wobei der Generierung eines hinsichtlich eines Nährungszustandes eine kombinierte Betrachtung von zwei Signalen zugrundegelegt wird, wobei ein hierbei verwendetes erstes Signal ein Signal ist, das mit der Belastung des Transmittersystemabschnitts korreliert und das zweite Signal ein Signal ist das die Stärke des an der Transmitterelektrodeneinrichtung anliegenden Feldes repräsentiert. Dieses Konzept kann auch unabhängig von den oben stehend beschriebenen, Trennelektroden einschließenden Konzept Anwendung finden.

Bei der Anwendung dieser Technik zur Observation des Bahnraumes einer Fahrzeugheckklappe kann die Transmitterelektrodeneinrichtung unmittelbar durch den Basiskörper einer Fahrzeugheckklappe realisiert sein. Diese Fahrzeugheckklappe ist hierzu vorzugsweise unter Einbindung einer Isolierstruktur an die Fahrzeugkarosserie angebunden. Auch die im Bereich der Fahrzeugheckklappe verbauten elektrischen Verbraucher sind über eine eigene Masseleitung an das Bordnetz angebunden. Die Transmitterelektrodeneinrichtung kann auch als anderweitige Struktur, z.B. als U-förmig entlang der unteren und seitlichen Kantenbereiche der Heckklappe an diesen entlanggeführte Flachmaterial- oder Drahtelektrode ausgebildet sein. Die Transmitterelektrodeneinrichtung kann auch anderweitig in die Heckklappe eingebunden sein. Insbesondere ist es auch möglich, die Transmitterelektrodeneinrichtung über die Heckscheibe, insbesondere eine in diese eingebundene Heckscheibenheizung zu realisieren.

Die Receiverelektrodeneinrichtung ist vorzugsweise im Bereich der Schließ- oder Dichtungskanten der Fahrzeugkarosserie angeordnet.

Bei dem ersten Signal kann es sich insbesondere um den Strom zur Transmitterelektrodeneinrichtung, insbesondere auch um die Leistungsaufnahme der Transmitterelektrodeneinrichtung, den Phasenwinkel zwischen Strom und Spannung, sowie auch um Charakteristika des zeitlichen Verlaufs von Strom und oder Spannung im Bereich des Transmittersystems handeln.

Bei dem zweiten Signal handelt es sich vorzugsweise um ein Signal das unmittelbar mit der Feldstärke des zur Receiverelektrodeneinrichtung vordringenden Feldes korreliert.

Die Detektionsanordnung kann auch umgekehrt realisiert werden, d.h. Heckklappenseitige Komponenten fungieren als Receiverelektroden und karosserieseitige Elektrodenstrukuren fungieren als Transmitterelektroden.

Es ist möglich, für den Öffnungs- und Schließvorgang einer Hecklappe bestimmte Referenzinformationen, insbesondere Referenz-Signalverläufe vorzuhalten und zu überprüfen, ob während eines Öffnungs- oder Schließvorganges bestimmte Abweichungen von diesen Referenzvorgängen auftreten.

Weitere Einzelheiten und Merkmale der Erfindung ergeben sich aus der nachfolgenden Beschreibung in Verbindung mit der Zeichnung. Es zeigt:
- **Fig.1**: eine Schemadarstellung zur Veranschaulichung des Basiskonzeptes eines erfindungsgemäßen Sensorsystems bei welchem die Detektion von Näherungsvorgängen auf der Basis einer Feldabsorption erfolgt;
- **Fig.2**: eine Ersatzschaltung des Sensorsystems im Grundzustand;
- **Fig.3**: eine Ersatzschaltung des Sensorsystems bei Anwesenheit eines Körperteils im Feld;
- **Fig.4a**: eine Schaltungsanordnung mit LC-Schwingkreis zur Ansteueuerung der Transmitterelektrode;
- **Fig.4b**: eine Schaltungsanordnung mit Übertrager zur Ansteuerung der Transmitterelektrode;
- **Fig.5**: ein Anwendungsbeispiel für eine Absicherung einer Fahrzeug Heckklappe gegen Einklemmen menschlicher Gliedmaßen;
- **Fig.6**: eine Schemadarstellung zur Veranschaulichung einer Detektionsschaltungseinrichtung bei welcher sowohl im sendeseitigen Bereich abgreifbare Charakteristika, als auch im empfangsseitigen Bereich über die jeweiligen Schaltungsabschnitte abgreifbare Charakteristika bei der Generierung von Auswertungsergebnissen die als solche über das Vorliegen eines Näherungszustandes Aufschluss geben, Berücksichtigung finden.

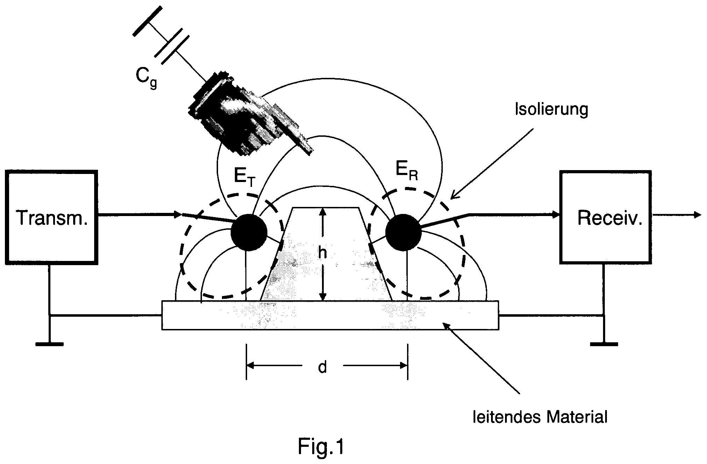

Die in Fig.1 dargestellte Anordnung zeigt einen schematisierten Aufbau zur Erläuterung der prinzipiellen Wirkungsweise der erfindungsgemäßen Schaltungsanordnung. Die hier gezeigte Querschnittsgestaltung der Elektroden kann den Anforderungen des jeweiligen Anwendungsfalls entsprechend auch in abweichender Form vorgenommen werden. So könnte z.B. die Form des Steges auch rund sein. Generell gilt jedoch der Zusammenhang, dass die Elektrodendistanz d zur Erzielung des gewünschten Effektes umso größer sein muss, je kleiner die Steghöhe h ist.

Die erfindungsgemäße Anordnung gemäß Figur 1 umfasst zwei Elektroden E_{T} und E_{R}, von denen eine durch einen Transmitter angesteuert wird und die zweite Elektrode E_{R} an einen Receiver angeschlossen ist. Der Transmitter erzeugt dabei in Verbindung mit der Elektrode E_{T} ein elektrisches Wechselfeld mit einer Frequenz, die in der näheren Umgebung um diese Elektrode zu einer Nahfeldverteilung führt. Beide Elektroden sind durch einen leitenden Körper aus Metall oder leitfähigem Gummi so gegeneinander abgeschirmt, dass nur ein Teil des vom Transmitter erzeugten Feldes zur Empfangselektrode gelangt und dort vom angeschlossenen Receiver als Signal ausgegeben wird. Der von der Transmitterelektrode an der Receiverelektrode erzeugte Feldanteil ist entscheidend von der Geometrie der Elektroden, insbesondere vom Abstand d zueinander und von der Höhe h eines Steges des zwischen den Elektroden wirkenden leitfähigen Materials abhängig. Die Wahl dieser geometrischen Parameter und die genaue Form des leitfähigen Trägermaterials hängt jeweils von der spezifischen Anwendung ab.

Die Sensorfunktion dieser Anordnung für die Detektion eines Körperteiles ergibt sich dadurch, dass durch ein in das Feld eintauchendes Körperteil ein Teil des Feldes an der Receiverelektrode dadurch absorbiert wird, dass der menschliche Körper leitend ist und weiterhin gegenüber Erde eine Kapazität C_{g} aufweist , wodurch die Feldliniendichte an der Receiverelektrode abnimmt und dadurch die am Receiver ausgegeben Signalamplitude reduziert. Je geringer die Feldliniendichte an der Receiverelektrode im Grundzustand ist, umso empfindlicher wird die Anordnung für die Detektion eines Körperteils. Allerdings wird dann auch die Signalamplitude im Grundzustand der Anordnung kleiner. Bei der praktischen Anwendung eines solchen Systems wird daher ein auf den konkreten Einsatzfall abgestimmter Betriebspunkt zwischen einer für einen sicheren Betrieb notwendigen Signalamplitude und einer ausreichenden Empfindlichkeit eingestellt.

Ein entscheidender Unterschied zwischen der erfindungsgemäßen Anordnung und herkömmliche kapazitiven Sensoren besteht darin, dass die Funktion der Transmitter- und Receiverelektrode voneinander getrennt wird und die Feldkopplung zwischen den beiden Elektroden so gestaltet wird, dass der oben beschriebene Sensoreffekt eintritt. Durch die Separierung der Receiverelektrode ist es ferner möglich, schädliche Einflüsse von Feuchtigkeit und Metallteilen in der Nähe der Elektroden weitgehend dadurch zu eliminieren, dass die Eingangsimpedanz der an der Receiverelektrode angeschlossenen Empfangselektronik in der nachstehend beschriebenen Weise gestaltet wird.

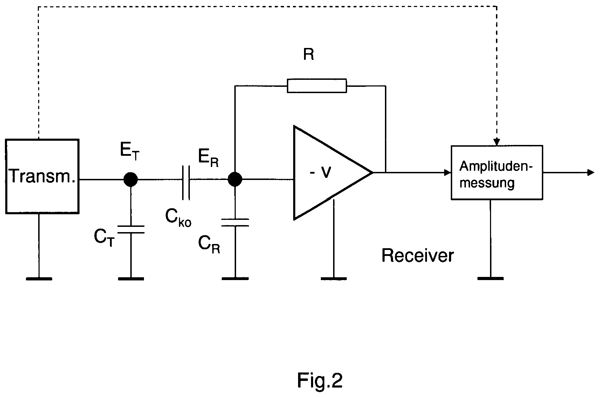

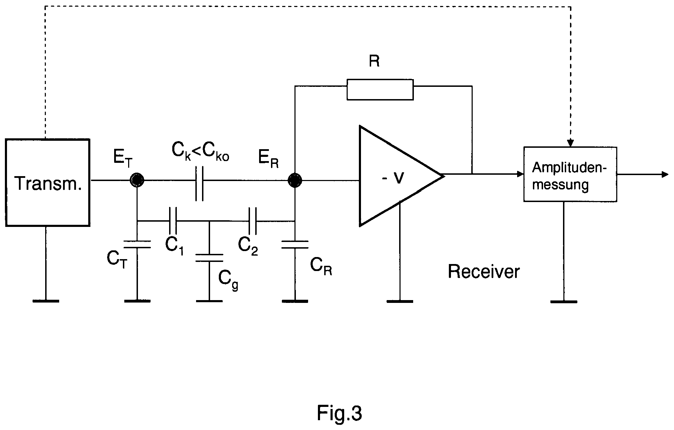

Die Wirkungsweise der Sensoranordnung wird nachfolgend in Verbindung mit den in Fig.2 und Fig.3 dargestellten Ersatzbildern näher erläutert. Die Feldkopplung zwischen Transmitter- und Receiverelektroden wird durch eine Kopplungskapazität Cₖ₀ repräsentiert, die entscheidend für die Signalamplitude am Ausgang eines Transimpedanzverstärkers ist. Ein besonderes Merkmal eines solchen Verstärkers mit der Leerlaufverstärkung -V ist es, dass am Eingang eine virtuelle Impedanz von näherungsweise Zₑ = R/V erscheint, wodurch die Eingangsimpedanz bei hinreichend großem V sehr gering wird. Typische Werte liegen mit R= 500 kOhm und V= 1000 dann bei Zₑ = 500 Ohm. Alle kapazitiven Änderungen am Elektrodeneingang durch Feuchtigkeit oder Metallteile werden dann praktisch vernachlässigbar , da die Eingangsimpedanz auch durch eine zu R/V parallel liegende Kapazität nicht wesentlich geändert wird. (Im Gegensatz hierzu arbeiten herkömmliche kapazitive Näherungssensoren an hochohmigen Verstärkereingängen mit den erwähnten Nachteilen bezüglich der Umwelteinflüsse.) Am Ausgang des Transimpedanzverstärkers ist noch eine weitere Stufe zur Amplitudenmessung angeschlossen, um aus der empfangenen Wechselspannung eine Gleichspannung zu gewinnen, die dann mittels eines A/D-Wandlers in einem Mikrocontroller weiterverarbeitet werden kann. Für die Gewinnung dieser zur Kopplungskapazität proportionalen Gleichspannung kann entweder eine Spitzenwertmesser mit Dioden oder ein Synchrondemodulator verwendet werden, der dann mit einer frequenzgleichen und um 90° in der Phase verschobenen Trägersignal aus dem Transmitter angesteuert wird. Die 90° Phasendrehung ist erforderlich, da die Ausgangsspannung des Transimpedanzverstärkers wegen der kapazitiven Kopplung ebenfalls um 90° gegenüber der vom Transmitter abgegebenen Spannung phasenverschoben ist.

Taucht ein Körperteil in das Feld, wird wegen des erläuterten Absorptionseffektes die Kopplungskapazität auf einen Wert Cₖ<Cₖ₀ reduziert und die am Ausgang des Transimpedanzverstärkers abgegebene Signalspannung sinkt proportional zu Cₖ. Alle übrigen bei der Kopplung mit dem Körperteil wirksamen Kapazitäten C₁ und C₂ zwischen den Elektroden (siehe Fig.3) sind wegen der Groundkapazität C_{g} des Körpers und wegen der niedrigen Eingangsimpedanz des Verstärkers in ihrer Wirkung auf die Signalamplitude vernachlässigbar. Der entscheidende Effekt ist die Reduzierung der Kopplungskapazität infolge der geringeren Feldliniendichte an der Receiverelektrode. Wassereinflüsse an beiden Elektroden führen zwar zu einer Erhöhung der Kapazitäten C₁ und C₂ sind jedoch vernachlässigbar, wie oben erläutert wurde. Lediglich eine direkte Wasserverbindung zwischen den Elektroden würde zu einer Vergrößerung der Kopplungskapazität führen. Dem kann jedoch durch Wahl geeigneter Abstände d , Steghöhe h und geeignete Isolierung der Elektroden entgegengewirkt werden. Die zweckmäßigste Konfiguration des Sensors hängt jeweils maßgeblich von der tatsächlichen Einbausituation ab.

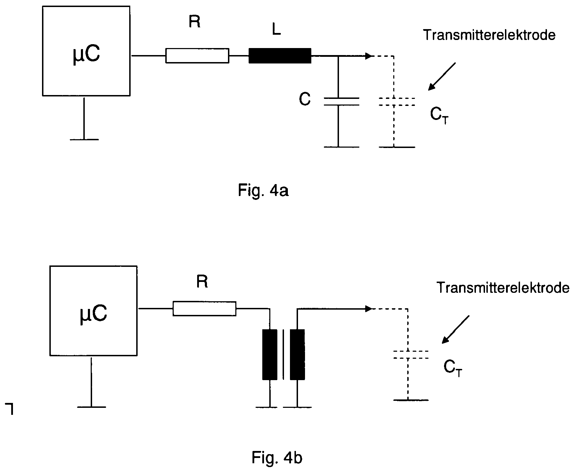

In Fig.4 sind zwei Varianten einer Ansteuerung der Transmitterelektrode aus einem Mikrocontroller dargestellt. Die erste Variante in Fig. 4a verwendet einen Serien-Resonanzkreis, für den die Elektrodenkapazität C_{T} ein Teil der Gesamtkapazität darstellt. Der Kreis wird dann zusammen mit einer Zusatzkapazität und der Induktivität auf die Trägerfrequenz des Transmitters abgestimmt, die typisch im Bereich 100 bis 200 kHz liegt. Die hiermit an der Transmitterelektrode erzeugten Spannungen liegen dann bei 20 bis 30 V. Fig.4b zeigt eine Ansteuerung mit Übertrager , der die vom Mikrocontroller gelieferte Trägerspannung auf eine höhere Elektrodenspannung transformiert. Bedingt durch die Elektrodenkapazität C_{T} entsteht auf der Sekundärseite des Übertragers ein Parallelschwingkreis , dessen Resonanzfrequenz durch geeignete Wahl der sekundärseitigen Induktivität auf die verwendete Trägerfrequenz abgestimmt wird. Der Vorteil dieser Variante gegenüber der Anordnung von Fig.4a besteht darin, dass bei Änderungen in der Elektrodenkapazität z.B. durch variierende Abstände der Transmitterelektrode zu Masseflächen die Elektrodenspannung sich weniger ändert als bei der Anordnung gemäß Fig. 4a. Hierfür ist allerdings ein höherer Kostenaufwand durch den Übertrager notwendig. Welche Variante verwendet wird, hängt jeweils von der spezifischen Anwendung ab.

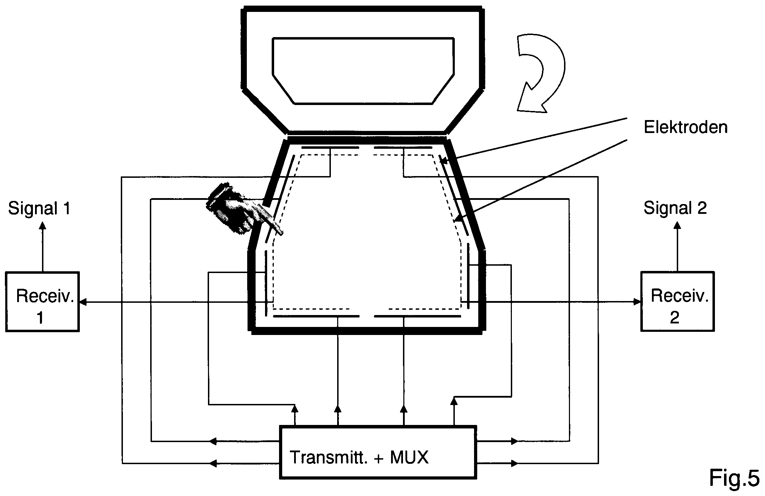

Fig.5 veranschaulicht einen konkreten Anwendungsfall der Erfindung bei der Realisierung eines Sensorsystems für eine Heckklappenabsicherung an einem Fahrzeug. Die beiden Elektroden sind an den abzusichernden Kanten des Hecks entlang geführt und in zwei getrennte Links- und Rechtssysteme aufgeteilt. Diese Maßnahme hat den Vorteil, dass die Heckklappenbewegung, die am Ende des Schließvorganges zu einer Beeinflussung der Kopplungskapazität zwischen Transmitter- und Receiverelektrode führt eliminiert werden kann, indem das jeweils von der gegenüberliegenden Elektrode gelieferte Signal als Referenz für das andere Signal verwendet wird. Durch diese Signalkorrelation ist keine weitere Information über die Heckklappenstellung erforderlich.

Die vorgenannte Maßnahme führt außerdem auch dazu, dass links und rechts gleich oder ähnlich einwirkende Störgrößen weitgehend kompensiert werden. Eine Besonderheit des Systems liegt darin, dass an jeder Seite mehrere Transmitterelektroden verwendet werden, wodurch die Kopplungen auf die zugehörige gemeinsame Receiverelektrode verringert wird und dadurch die einzelnen Koppelkapazitäten kleiner sind als bei einer Kopplung über eine an allen Kanten durchgehende Transmitterelektrode. Dies erhöht einmal die Empfindlichkeit des System auf eintauchende Körperteile und zum anderen verringert es vorteilhaft die Signaldynamik in den Receivern, wodurch Übersteuerungen vermieden werden. Vorzugsweise werden die Transmitterelektroden zeitlich nacheinander über einen Multiplexer mit dem Sendesignal angesteuert , wodurch Detektionsereignisse auch einzelnen Observationsabschnitten zugeordnet und mit Prioritäten versehen werden könnten.

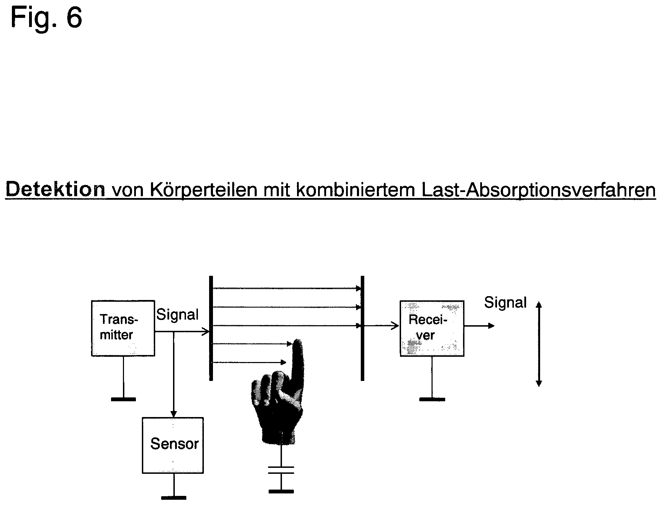

In Figur 6 ist eine Detektionsanordnung dargestellt die gemäße einem weiteren erfindungsgemäßen Lösungsansatz auch unabhängig von den vorangehend beschriebenen Maßnahmen eine zuverlässige Erfassung von Objekten, insbesondere Lebewesen in einem Observationsbereich ermöglicht. Erfindungsgemäß umfasst diese Detektionsanordnung eine Transmitterelektrodeneinrichtung zur Einkoppelung eines elektrischen Wechselfeldes in die Observationszone oder deren Umgebungsbereich, und eine Receiverelektrodeneinrichtung zur Erfassung eines elektrischen Feldes in der Observationszone oder des genannten Umgebungsbereiches, wobei der Generierung eines hinsichtlich eines Nährungszustandes eine kombinierte Betrachtung von zwei Signalen zugrundegelegt wird, wobei ein hierbei verwendetes erstes Signal ein Signal ist, das mit der Belastung des Transmittersystemabschnitts korreliert und das zweite Signal ein Signal ist das die Stärke des an der Transmitterelektrodeneinrichtung anliegenden Feldes repräsentiert.

Bei der Anwendung dieser Technik zur Observation des Bahnraumes einer Fahrzeugheckklappe kann die Transmitterelektrodeneinrichtung unmittelbar durch den Basiskörper einer Fahrzeugheckklappe realisiert sein.

Diese Fahrzeugheckklappe ist hierzu vorzugsweise unter Einbindung einer Isolierstruktur an die Fahrzeugkarosserie angebunden. Auch die im Bereich der Fahrzeugheckklappe verbauten elektrischen Verbraucher sind über eine eigene Masseleitung an das Bordnetz angebunden. Die Transmitterelektrodeneinrichtung kann auch als anderweitige Struktur, z.B. als U-förmig entlang der unteren und seitlichen Kantenbereiche der Heckklappe an diesen entlanggeführte Flachmaterial- oder Drahtelektrode ausgebildet sein. Die Transmitterelektrodeneinrichtung kann auch anderweitig in die Heckklappe eingebunden sein. Insbesondere ist es auch möglich, die Transmitterelektrodeneinrichtung über die Heckscheibe, insbesondere eine in diese eingebundene Heckscheibenheizung zu realisieren.

Die Receiverelektrodeneinrichtung ist vorzugsweise im Bereich der Schließ- oder Dichtungskanten der Fahrzeugkarosserie angeordnet.

Bei dem ersten Signal kann es sich insbesondere um den Strom zur Transmitterelektrodeneinrichtung, insbesondere auch um die Leistungsaufnahme der Transmitterelektrodeneinrichtung, den Phasenwinkel zwischen Strom und Spannung, sowie auch um Charakteristika des zeitlichen Verlaufs von Strom und oder Spannung im Bereich des Transmittersystems handeln.

Bei dem zweiten Signal handelt es sich vorzugsweise um ein Signal das unmittelbar mit der Feldstärke des zur Receiverelektrodeneinrichtung vordringenden Feldes korreliert.

Die Detektionsanordnung kann auch umgekehrt realisiert werden, d.h. Heckklappenseitige Komponenten fungieren als Receiverelektroden und karosserieseitige Elektrodenstrukuren fungieren als Transmitterelektroden.

Es ist möglich, für den Öffnungs- und Schließvorgang einer Hecklappe bestimmte Referenzinformationen, insbesondere Referenz-Signalverläufe vorzuhalten und zu überprüfen, ob während eines Öffnungs- oder Schließvorganges bestimmte Abweichungen von diesen Referenzvorgängen auftreten.

## Patentansprüche

1. Detektionsanordnung zur Erfassung der Annäherung, oder der Präsenz von Objekten, insbesondere belebten Gliedmaßen an, bzw. in einer
Observationszone, mit:
- einer Transmitterelektrodeneinrichtung (E_{T}) zur Einkoppelung eines elektrischen Wechselfeldes in die Observationszone sowie deren Umgebungsbereich,
- einer von der Transmitterelektrodeneinrichtung (E_{T}) beabstandete Receiverelektrodeneinrichtung (E_{R}) zur Erfassung des in
der Observationszone oder des im genannten Umgebungsbereiches erzeugten elektrischen Wechselfeldes welche sich von der Transmitterelektrodeneinrichtung (E_{T}) zur Receiverelektrodeneinrichtung (E_{R}) erstreckt, und
- einer zwischen der von der Transmitterelektrodeneinrichtung (E_{T}) und der Receiverelektrodeneinrichtung (E_{R}) angeordnete Trennelektrodeneinrichtung, zur Abschirmung eines Teiles des sich
zwischen der Transmitterelektrode (E_{T}) und der Receiverelektrode (E_{R}) ausbreitenden Feldes,
**dadurch gekennzeichnet, dass** die Trennelektrodeneinrichtung aus einem Metallwerkstoff oder aus einem leitfähigen Kunststoff, insbesondere Elastomermaterial, gefertigt ist und dass die Trennelektrodeneinrichtung sich unterhalb der Transmitterelektrodeneinrichtung (E_{T}) und der Receiverelektrodeneinrichtung (E_{R}) erstreckt und einen Stegabschnitt umfasst der sich in einem Bereich zwischen der Transmitterelektrodeneinrichtung (E_{T}) und der Receiverelektrodeneinrichtung (E_{R}) vertikal erstreckt.

2. Detektionsanordnung nach Anspruch 1, **dadurch**
**gekennzeichnet**, das die Transmitterelektrodeneinrichtung (E_{T}) und die Receiverelektrodeneinrichtung (E_{R}) als drahtartige Elektrodenstrukturen ausgeführt sind, und dass die Transmitterelektrodeneinrichtung (E_{T}) und die Receiverelektrodeneinrichtung (E_{R}) als zueinander im Wesentlichen äquidistant geführte Elektrodeneinrichtungen angeordnet sind, und dass ein sich unterhalb der Transmitterelektrodeneinrichtung (E_{T}) und der Receiverelektrodeneinrichtung (E_{R}) erstreckender Bereich der Trennelektrodeneinrichtung
einen der Observationszone abgewandten rückwärtigen Bereich abschirmt.

3. Detektionsanordnung nach wenigstens einem der Ansprüche 1 oder 2, **dadurch gekennzeichnet, dass** die Trennelektrodeneinrichtung einen T-Profilquerschnitt aufweist.

4. Detektionsanordnung nach wenigstens einem der Ansprüche 1 bis 3, **dadurch gekennzeichnet, dass** die Transmitterelektrodeneinrichtung (E_{T}) und die Receiverelektrodeneinrichtung (E_{R}) in eine Dichtungseinrichtung eingebunden sind, und dass die Trennelektrodeneinrichtung eine Mittelpunktselektrode bildet.

5. Detektionsanordnung nach wenigstens einem der Ansprüche 1 bis 4, **dadurch gekennzeichnet, dass** der Signalabgriff an der Receiverelektrodeneinrichtung (E_{R}) über eine Transimpedanzschaltung erfolgt, wobei die Transimpedanzschaltung derart konfiguriert ist, dass die Eingangsimpedanz Z_{C} an der Receiverelektrodeneinrichtung Z_{c}=R/V ist, wobei V die Verstaerkung der Transimpedanzschaltung ist und R der Betrag des Rückkopplungswiderstandes ist.

6. Detektionsanordnung nach Anspruch 5, **dadurch gekennzeichnet dass** die Eingangsimpedanz 500 Ohm beträgt.

7. Detektionsanordnung nach Anspruch 5 oder 6, **dadurch gekennzeichnet dass** einem Ausgang des Transimpedanzverstärkers eine weitere Stufe zur Amplitudenmessung angeschlossen ist, um aus der empfangenen Wechselspannung eine Gleichspannung zu gewinnen.

8. Detektionsanordnung nach Anspruch 7, **dadurch gekennzeichnet dass** die Gleichspannung mittels eines AD-Wandlers in einem Mikrocontroller weiterverarbeitet wird.

9. Detektionsanordnung nach Anspruch 7 oder 8,**dadurch gekennzeichnet dass** die Stufe zur Amplitudenmessung entweder durch einen Spitzenwertmesser mit Dioden oder einen Synchrondemodulator gebildet wird.

10. Detektionsanordnung nach Anspruch 9, **dadurch gekennzeichnet dass** die Stufe zur Amplitudenmessung mit einer frequenzgleichen und einem um 90° in der Phase verschobenen Trägersignal aus dem Transmitter angesteuert wird.

11. Detektionsanordnung nach wenigstens einem der Ansprüche 1 bis 10, **dadurch gekennzeichnet dass** eine Trägerfrequenz eines Signals an der Transmitterelektrodeneinrichtung (E_{T}) im Bereich von 100 bis 200 kHz liegt und dass eine an der Transmitterelektrodeneinrichtung (E_{T}) erzeugte Spannung zwischen 20 bis 30 V liegt.

12. Detektionsanordnung nach wenigstens einem der Ansprüche 1 bis 11, **dadurch gekennzeichnet, dass** die Funktion der Transmitter- und Receiverelektrodeneinrichtung (E_{T}, E_{R}) voneinander getrennt wird und dass ein Detektionsereignis anhand von Merkmalen der Feldkopplung zwischen den beiden Elektrodeneinrichtungen (E_{T}, E_{R}) detektiert wird.

13. Detektionsanordnung nach wenigstens einem der Ansprüche 1 bis 12, **dadurch gekennzeichnet, dass** Elektrodeneinrichtungen (E_{T}, E_{R}) als flach-bandartige oder anderweitig länglich flächenhafte Strukturen ausgeführt sind, und dass als Material für die Elektrodeneinrichtungen (E_{T}, E_{R}) ein leitfähiges Kunststoffmaterial, insbesondere Elastomermaterial verwendet wird.

14. Detektionsanordnung nach wenigstens einem der Ansprüche 1 bis 13,
**dadurch gekennzeichnet, dass** Elektrodeneinrichtungen (E_{T}, E_{R}) die Transmitter und/ oder Receiverelektrodeneinrichtung (E_{T}, E_{R}) m mehrere Elektrodenabschnitte unterteilt ist, und dass diese separaten Elektrodenabschnitte separat angesteuert werden, wobei die Ansteuerung der Elektrodeneinrichtungen, insbesondere der Receiverelektrodeneinrichtung über einen Multiplexer erfolgt, und dass über die von den separaten Elektrodeneinrichtungen abgegriffenen Signalen eine Bereichszuordnung der erfassten Näherungsvorgänge erfolgt.

## Claims

1. A detection device for detecting the approach or the presence of objects, particularly animated extremities, at and in an observation zone, respectively, comprising:
- a transmitter electrode device (E_{T}) for coupling an electric alternating field in the observation zone and its surrounding area,
- a receiver electrode device (E_{R}) spaced apart from the transmitter electrode device (E_{T}) for detecting the electric alternating field generated in the observation zone or said surrounding area and extending from the transmitter electrode device (E_{T}) to the receiver electrode device (E_{R}), and
- a separator electrode device arranged between the transmitter electrode device (E_{T}) and the receiver electrode device (E_{R}) for shielding a portion of the field spreading out between the transmitter electrode (E_{T}) and the receiver electrode (E_{R}),
**characterized in that** the separator electrode device is made of a metallic material or of a conductive synthetic material, in particular elastomer material, and **in that** the separator electrode device extends below the transmitter electrode device (E_{T}) and the receiver electrode device (E_{R}) and comprises a separator section which extends vertically in an area between the transmitter electrode device (E_{T}) and the receiver electrode device (E_{R}).

2. The detection device of claim 1, **characterized in that** the transmitter electrode device (E_{T}) and the receiver electrode device (E_{R}) are carried out as wire-like electrode structures, and **in that** the transmitter electrode device (E_{T}) and the receiver electrode device (E_{R}) are arranged with respect to each other as substantially equidistant conducted electrode devices, and **in that** an area of the separator electrode device extending below the transmitter electrode device (E_{T}) and the receiver electrode device (E_{R}) shields a rear area averted from the observation zone.

3. The detection device of at least one of claims 1 or 2, **characterized in that** the separator electrode device has a T-shaped profile cross section.

4. The detection device of at least one of claims 1 to 3, **characterized in that** the transmitter electrode device (E_{T}) and the receiver electrode device (E_{R}) are integrated into a sealing device, and **in that** the separator electrode device forms a center electrode.

5. The detection device of at least one of claims 1 to 4, **characterized in that** the signal pickup at the receiver electrode device (E_{R}) is carried out via a transimpedance circuit, wherein the transimpedance circuit is configured such, that the input impedance Z_{c} at the receiver electrode device is Z_{c} = R/V, wherein V is the amplification of the transimpedance circuit and R is the modulus of the feedback resistance.

6. The detection device of claim 5, **characterized in that** the input impedance is 500 Ohms.

7. The detection device of claim 5 or 6, **characterized in that** a further stage for amplitude measurement is connected to an output of the transimpedance amplifier to obtain a direct voltage from the received alternating voltage.

8. The detection device of claim 7, **characterized in that** the direct voltage is further processed by means of an analog digital converter in a microcontroller.

9. The detection device of claim 7 or 8, **characterized in that** the stage for amplitude measurement is either formed by a peak value measurement device comprising diodes or by a synchronous demodulator.

10. The detection device of claim 9, **characterized in that** the stage for amplitude measurement is driven by means of a carrier signal of equal frequency and shifted in phase by 90° originating from the transmitter.

11. The detection device of at least one of claims 1 to 10, **characterized in that** a carrier frequency of a signal at the transmitter electrode device (E_{T}) is in the range of 100 to 200 kHz and **in that** a voltage generated at the transmitter electrode device (E_{T}) is between 20 to 30 V.

12. The detection device of at least one of claims 1 to 11, **characterized in that** the function of the transmitter and receiver electrode device (E_{T}, E_{R}) is separated from each other and **in that** a detection event is detected by means of characteristics of the field coupling between the two electrode devices (E_{T}, E_{R}).

13. The detection device of at least one of claims 1 to 12, **characterized in that** electrode devices (E_{T}, E_{R}) are carried out as flat ribbon-like or otherwise elongated extensive structures, and **in that** a conductive synthetic material, in particular elastomer material, is used as material for the electrode devices (E_{T}, E_{R}).

14. The detection device of at least one of claims 1 to 13, **characterized in that** the transmitter and / or receiver electrode devices (E_{T}, E_{R}) are partitioned into several electrode segments, and **in that** these separate electrode segments are driven separately, wherein the activation of the electrode devices, in particular of the receiver electrode device, is carried out via a multiplexer, and **in that** an area mapping of the detected approach events is carried out via the signals picked off from the separate electrode devices.

## Revendications

1. Système de détection destiné à la détection de l'approche ou de la présence d'objets, en particulier de membres animés, sur ou respectivement dans une zone d'observation, avec :
- un dispositif d'électrode d'émission (E_{T}) pour le couplage d'un champ alternatif électrique en direction de la zone d'observation ainsi que de son espace environnant,
- un dispositif d'électrode de réception (E_{R}), distant du dispositif d'électrode d'émission (E_{T}), destiné à la détection du champ alternatif électrique produit dans la zone d'observation ou dans ledit espace environnant qui s'étend à partir du dispositif d'électrode d'émission (E_{T}) vers le dispositif d'électrode de réception (E_{R}), et
- un dispositif d'électrode de séparation disposé entre le dispositif d'électrode d'émission (E_{T}) et le dispositif d'électrode de réception (E_{R}), destiné au blindage d'une partie du champ se propageant entre le dispositif d'électrode d'émission (E_{T}) et le dispositif d'électrode de réception (E_{R}),
**caractérisé en ce que** le dispositif d'électrode de séparation est fabriqué en matériau métallique ou en matière plastique conductrice, en particulier un matériau élastomère, et **en ce que** le dispositif d'électrode de séparation s'étend au-dessous du dispositif d'électrode d'émission (E_{T}) et du dispositif d'électrode de réception (E_{R}) et comprend un tronçon de barrette qui s'étend verticalement dans un espace entre le dispositif d'électrode d'émission (E_{T}) et le dispositif d'électrode de réception (E_{R}).

2. Système de détection selon la revendication 1, **caractérisé en ce que** le dispositif d'électrode d'émission (E_{T}) et le dispositif d'électrode de réception (E_{R}) sont réalisés en tant que structures d'électrode du type filaire, et **en ce que** le dispositif d'électrode d'émission (E_{T}) et le dispositif d'électrode de réception (E_{R}) sont disposés en tant que dispositifs d'électrode guidés de façon essentiellement équidistante l'un par rapport à l'autre, et **en ce qu'**un espace du dispositif d'électrode de séparation s'étendant au-dessous du dispositif d'électrode d'émission (E_{T}) et du dispositif d'électrode de réception (E_{R}) blinde un espace arrière éloigné de la zone d'observation.

3. Système de détection selon au moins l'une des revendications 1 ou 2, **caractérisé en ce que** le dispositif d'électrode de séparation présente une section transversale à profil en T.

4. Système de détection selon au moins l'une des revendications 1 à 3, **caractérisé en ce que** le dispositif d'électrode d'émission (E_{T}) et le dispositif d'électrode de réception (E_{R}) sont intégrés dans un dispositif d'étanchéité, et **en ce que** le dispositif d'électrode de séparation forme une électrode de point central.

5. Système de détection selon au moins l'une des revendications 1 à 4, **caractérisé en ce que** la prise de signal s'effectue sur le dispositif d'électrode de réception (E_{R}) par le biais d'un circuit à impédance transversale, le circuit à impédance transversale étant configuré de telle sorte que l'impédance d'entrée Z_{C} sur le dispositif d'électrode de réception est Z_{c} = R/V, V étant l'amplification du circuit à impédance transversale et R la valeur de la résistance de rétroaction.

6. Système de détection selon la revendication 5, **caractérisé en ce que** l'impédance d'entrée est égale à 500 ohms.

7. Système de détection selon la revendication 5 ou 6, **caractérisé en ce qu'**un étage supplémentaire destiné à la mesure d'amplitude est connecté à une sortie de l'amplificateur à impédance transversale pour obtenir une tension continue à partir de la tension alternative reçue.

8. Système de détection selon la revendication 7, **caractérisé en ce que** la tension continue fait l'objet d'un traitement complémentaire au moyen d'un convertisseur A/N dans un microcontôleur.

9. Système de détection selon la revendication 7 ou 8, **caractérisé en ce que** l'étage destiné à la mesure d'amplitude est formé soit par un organe de mesure de valeurs de pointe avec des diodes, soit par un démodulateur synchrone.

10. Système de détection selon la revendication 9, **caractérisé en ce que** l'étage destiné à la mesure d'amplitude est commandé à partir de l'émetteur avec un signal porteur de même fréquence déphasé de 90°.

11. Système de détection selon au moins l'une des revendications 1 à 10, **caractérisé en ce qu'**une fréquence porteuse d'un signal sur le dispositif d'électrode d'émission (E_{T}) se situe dans la plage de 100 à 200 kHz, et **en ce qu'**une tension produite sur le dispositif d'électrode d'émission (E_{T}) est comprise entre 20 et 30 V.

12. Système de détection selon au moins l'une des revendications 1 à 11, **caractérisé en ce que** la fonction du dispositif d'électrode d'émission (E_{T}) et celle de l'électrode de réception (E_{R}) sont séparées l'une de l'autre, et **en ce qu'**un événement de détection est détecté à l'aide de caractéristiques du couplage de champ entre les deux dispositifs d'électrode (E_{T}, E_{R}).

13. Système de détection selon au moins l'une des revendications 1 à 12, **caractérisé en ce que** des dispositifs d'électrode (E_{T}, E_{R}) sont réalisés en tant que structures du type ruban plat ou autrement allongées en nappe, et **en ce qu'**une matière plastique conductrice, en particulier un matériau élastomère, est utilisée en tant que matériau pour les dispositifs d'électrode (E_{T}, E_{R}).

14. Système de détection selon au moins l'une des revendications 1 à 13, **caractérisé en ce que** des dispositifs d'électrode d'émission (E_{T}, E_{R}) et/ou de réception (E_{T}, E_{R}) sont subdivisés en plusieurs segments d'électrode, et **en ce que** ces segments d'électrode séparés sont commandés séparément, la commande des dispositifs d'électrode, en particulier du dispositif d'électrode de réception, s'effectuant par le biais d'un multiplexeur, et **en ce qu'**une affectation d'espace des processus d'approche détectés s'effectue par le biais des signaux pris sur les dispositifs d'électrode séparés.
